Europäisches Patentamt

European Patent Office

Office européen des brevets

(11) Publication number: **0 024 735**
**B1**

# (12) EUROPEAN PATENT SPECIFICATION

(45) Date of publication of patent specification: **16.01.85**

(21) Application number: **80105168.1**

(22) Date of filing: **29.08.80**

(51) Int. Cl.⁴: **H 01 L 29/60,** H 01 L 27/10,
G 11 C 11/34

(54) **Nonvolatile semiconductor memory device.**

(30) Priority: **31.08.79 JP 111111/79**

(43) Date of publication of application:
**11.03.81 Bulletin 81/10**

(45) Publication of the grant of the patent:
**16.01.85 Bulletin 85/03**

(84) Designated Contracting States:
**DE FR GB**

(56) References cited:
FR-A-1 408 613
JP-A-54 093 375
US-A-3 825 945
US-A-4 161 039

IEEE Trans. Elect. Devices Vol. ED-24, No. 5,
May 1977 pp. 600-610
Patent Abstracts of Japan, Vol. 3, p. 125E140

(73) Proprietor: **Kabushiki Kaisha Toshiba
72, Horikawa-cho Saiwai-ku
Kawasaki-shi Kanagawa-ken 210 (JP)**

(72) Inventor: **Iwahashi, Hiroshi
1-6-7, Kaminomiya
Tsurumi-ku Yokohama-shi (JP)**
Inventor: **Asano, Masamichi
2-24-12, Naka-cho Musashino-shi
Tokyo (JP)**

(74) Representative: **Patentanwälte Henkel,
Pfenning, Feiler, Hänzel & Meinig
Möhlstrasse 37
D-8000 München 80 (DE)**

Courier Press, Leamington Spa, England.

## Description

The invention relates to a nonvolatile semiconductor memory device comprising: a semiconductor substrate of one conductivity type; a drain region which has two end portions and is formed on a major surface of said semiconductor substrate; a contact hole formed substantially in the middle of the drain region between said two end portions; first and second source regions formed on both sides of the drain region, respectively, in such a way as to be spaced apart from the two end portions of the drain region by a predetermined distance; first and second channel regions respectively formed between one end of the drain region and the first source region, and between the other end of the drain region and the second source region; first and second floating gate electrodes formed on gate insulation films overlying both said first and second channel regions; and first and second control gate electrodes formed on another gate insulation film overlapping said floating gate electrodes extending along the longitudinal direction of the channels, between the source regions and the corresponding drain regions. In this nonvolatile semiconductor memory device the width of each of said floating gate electrodes and control gate electrodes is narrower at those portions which are located over said channel than at portions which are not located over said channel.

Furthermore, those side edges of the first and second floating and control gate electrodes which face to first and second source regions are substantially parallel with each other and extend in a substantial straight direction along the side edges of the source regions, whereas those portions of said floating and control gate electrodes which are not located over said channel protrude towards a direction parallel to the source-drain-direction at a given distance from said drain contact hole.

A nonvolatile semiconductor device is usually formed by using insulated-gate field effect transistors (IGFET). In this semiconductor memory device, charging and discharging on column lines connected with memory cells or IGFET's need to be accelerated in order to increase the speed of writing and reading of data. To attain this, the amount of current flowing through the channel of each IGFET needs to be increased. This amount of current is determined by a potential of the floating gate electrode which is a substantial gate electrode of the memory cell. The potential of the floating gate electrode at the time of impression of a potential to the control gate electrode is determined by the ratio of capacity created between the floating gate and control gate electrodes and the capacity created between the floating gate electrode and the substrate inclusive of the channel. One method for raising the potential of the floating gate to increase the amount of current is that, the capacity created between the control gate electrode and floating gate electrode must be greater than the capacity created between the floating gate electrode and semiconductor substrate inclusive of the channel.

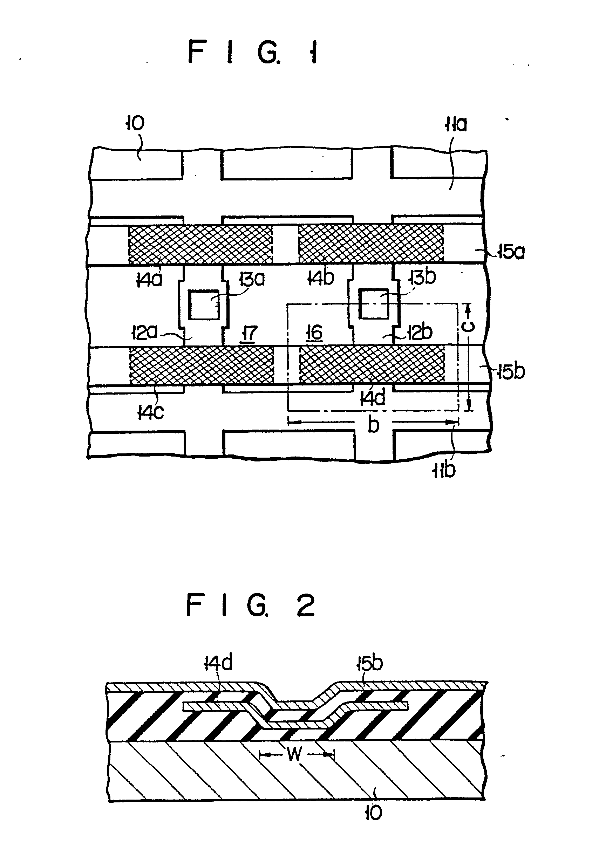

Figure 1 is a cutaway view of a semiconductor memory device developed to fulfill the aforementioned requirements, showing four memory cells. In Figure 1, N$^+$-type diffusion layers 11a and 11b to serve severally as source regions are formed substantially in parallel with each other in the row direction on the major surface of a P-type semiconductor substrate 10. N$^+$-type diffusion layers 12a and 12b to serve as common drain regions extend between the source regions 11a and 11b at a given distance from each other to form a channel therebetween. Drain contact holes 13a and 13b are formed in the middle of the drain regions 12a and 12b, respectively. Polycrystalline silicon layers 14a and 14b to serve as floating gate electrodes are formed on a gate insulation film overlying two channel portions between the source region 11a and the drain regions 12a and 12b, while a polycrystalline silicon layer 15a to serve as a control gate electrode is formed on another gate insulation film overlying the floating gate electrodes 14a and 14b. Likewise, floating gate electrodes 14c and 14d and a control gate electrode 15b are successively formed on gate insulation films overlying two channel portions between the other source region 11b and the drain regions 12a and 12b. Thus, an IGFET 16 is formed between the source region 11b and the drain region 12b, as indicated by a chain line in Figure 1, for example.

Figure 2 is a sectional view of the IGFET 16 taken along the channel portion in the row direction. In order to increase the capacity between the control gate electrode 15b and the floating gate electrode 14d, the IGFET 16 is so designed that portions thereof other than that portion which corresponds to the channel with width W may extend on both sides of the channel in the row direction along the control gate electrode 15b. As a result, the distance between the IGFET 16 and an IGFET 17 adjacent thereto is increased, as shown in Figure 1, and the dimensions $b \times c$ of IGFET 16 become 23.0 $\mu$m $\times$ 13.5 $\mu$m, for example. Thus, the row-direction dimension $b$ is expressly too large, so that the chip size of the memory device will be increased in the row direction.

"IEEE Transactions on Electron Devices", Vol. ED-24, May 1977, pages 600—606 and pages 606—610, respectively by A. Scheibe and H. Schulte (Technology of a new n-channel one-transistor EAROM cell called SIMOS) and by B. Rössler (Electrically erasable and reprogrammable read-only memory using the n-channel SIMOS one-transistor cell) discloses a non-volatile semi-conductor memory device comprising a semi-conductor substrate of one conductivity type, source and drain regions formed at a given distance from each other on a major surface of said semi-conductor substrate, a channel region formed between said source and drain regions, a floating gate electrode formed on one gate insulation film overlying said channel region, and a control gate electrode formed on another gate insulation film overlying said floating gate electrode. In this memory device, the capacitive coupling of the control gate to the floating gate is enhanced by overlapping these gates over a thick oxide layer outside the channel region. This known SIMOS EAROM matrix has a pattern in which the floating gate electrode has the same width in all regions in which it is arranged over diffusion areas. The publication, however, doesn't disclose a semiconductor memory device in which the width of each floating gate electrodes and control gate electrodes is narrower at those portions which are located over the channel region than at those portions which are not located over said channels region, in order to achieve a reduced chip size.

Accordingly, the object of the present invention is to provide a nonvolatile semiconductor memory device which is very compact and can select data in high speed.

In order to obtain the above object, the nonvolatile semiconductor memory device according to the invention is characterized in that those side edges of the first and second floating and control gate electrodes which face to first and second source regions and those side edges of the source regions are substantially in line with each other and that all those said portions of the floating and control gate electrodes which are not located over the channel, protrude towards the drain regions at a given distance from the drain contact hole.

The width of the facing portions of the floating gate electrode and the control gate electrode along the longitudinal direction of a channel between source and drain regions of each IGFET forming a memory cell is narrower at those portions which are located over the channel that at those portions which are not located over the channel.

This invention can be more fully understood from the following detailed description when taken in conjunction with the accompanying drawings, in which:

Figure 1 is a cutaway plan view of a prior art nonvolatile semiconductor memory device;

Figure 2 is a sectional view of one memory cell shown in Figure 1 taken along its channel portion;

Figure 3 is a cutaway plan view of a nonvolatile semiconductor memory device according to an embodiment of this invention;

Figure 4 is a plan view of a nonvolatile semiconductor memory device according to another embodiment of the invention;

Figure 5 is a sectional view of a memory cell shown in Figure 4 taken along its channel portion.

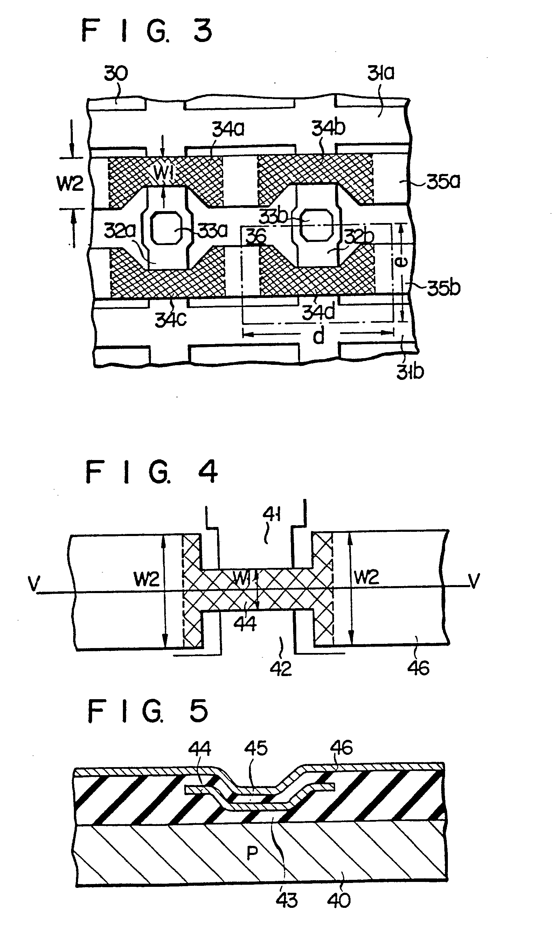

In Figure 3, $N^+$-type diffusion layers 31a and 31b to serve severally as source regions are formed substantially in parallel with each other in the row direction on the major surface of a P-type semiconductor substrate 30. $N^+$-type diffusion layers 32a and 32b to serve as common drain regions extend between the source regions 31a and 31b at a given distance from each other to form channels therebetween. Drain contact holes 33a and 33b are formed substantially in the middle of the drain regions 32a and 32b, respectively. Polycrystalline silicon layers 34a and 34b (reticulated portions) to serve as floating gate electrodes are formed on a gate insulation film overlying two channel portions between the source region 31a and the drain regions 32a and 32b, while a polycrystalline silicon layer 35a to serve as a control gate electrode is formed on another gate insulation film overlying the floating gate electrodes 34a and 34b. Those side edges of the control gate electrode 35a and another control gate electrode 35b which face respectively the source regions 31a and 31b extend in a straight line. The control gate electrode 35a and the floating gate electrodes 34a and 34b are so designed that their width W1 along the longitudinal direction of the channels between the source region 31a and the drain regions 32a and 32b at those portions which are located over the channels is narrower than the width W2 at those portions which are not located over the channels. Accordingly, those side edges of the floating gate electrodes 34a and 34b and the control gate electrode 35a which face the drain contact holes 33a and 33b overlap each other, and the portions of these electrodes which are not located over the channels protrude toward the other control gate electrode 35b.

Likewise, the floating gate electrodes 34c and 34d (reticulated portions) and the control gate electrode 35b of the same configuration as aforesaid are successively formed on gate insulation films overlying two channel portions between the other source region 31b and the drain regions 32a and 32b. Thus, four IGFET's are formed between the source regions 31a and 31b and the common drain regions 32a and 32b. For example, an IGFET 36 formed between the source region 31b and the drain region 32b is enclosed with a chain line in Figure 3. Here the row- and column-direction dimensions d and e of the IGFET 36 are 18.5 $\mu$m and 13.5 $\mu$m, respectively. Since the row-direction dimension b of the memory cell in the prior art memory device shown in Figure 1 is b=23.0 $\mu$m, the area of the IGFET 36 according to this invention is smaller than that of the IGFET 16 of Figure 1 by approximately 20%. Generally, in an integrated circuit such as a nonvolatile semiconductor memory device using IGFET's as its memory cells as has been described in this specification, the intervals between the row lines, that is, the intervals between the gate electrodes 35a and 35b and the drain contact holes 33a and 33b need to be kept larger than a given distance. This is inevitable for preventing a process error such as a possible deviation from the proper mask alignment during a photo engraving process (PEP). According to the embodiment of Figure 3, however, the control gate electrodes 35a and 35b jut out into a vacant space between the drain contact holes 33a and 33b, so that the memory cells are subject to no functional problems.

With such construction of the IGFET's to serve as memory cells, the row-direction dimension of each memory cell becomes smaller than that of the conventional one to provide a high-density nonvolatile semiconductor memory device, although the facing area between the floating gate electrode and control gate electrode, that is, the value of capacity formed therebetween is the same as that of the conventional one.

Figures 4 and 5 show another embodiment of the non-volatile semiconductor memory device of this invention. In Figures 4 and 5, $N^+$ type regions 41 and 42 are formed at a given distance from each other on the major surface of a P-type silicon substrate 40, serving respectively as a source region and a drain region. A floating gate electrode 44, extending in the widthwise direction (row direction) of a channel formed between the source and drain regions 41 and 42, is formed on a gate insulation film 43 formed of e.g. silicon dioxide overlying the channel. The floating gate electrode 44 is formed of e.g. polycrystalline silicon, and is so designed that a portion of the electrode 44 on the gate insulation film 43 corresponding to the channel has a smaller width W1 and those portions which are not located over the channel have a greater width W2. A control gate electrode 46 is formed on a gate insulation film 45 formed of e.g. silicon dioxide overlying the floating gate electrode 44 of such configuration. The control gate electrode 46 is formed of e.g. polycrystalline silicon, and is so designed that a portion thereof facing the floating gate electrode 44 is of substantially the same configuration as the electrode 44, extending with the width W2 in the row direction.

Also in the case of the embodiment shown in Figures 4 and 5, even if the facing area between the floating gate electrode 44 and control gate electrode 46 that is, the capacity between these electrodes is the same as that of the conventional one, the row-direction dimension of the memory cell can be reduced.

The configuration of the memory cell shown in Figure 4 has a sufficient allowance for a possible deviation from the proper mask alignment during the PEP comparing with that shown in Figure 1. For example, if a polycrystalline silicon layer used as both the control gate and floating gate electrodes deviates in the direction of lower part of Figure 1, i.e., the control gate electrode 15b and the floating gate electrode 14d deviate in the direction of the source region 11b in which the control gate electrode 15b and the floating gate electrode 14d overlap with the source region 11b, the capacity created between the floating gate electrode 14d and the substrate inclusive of the channel increases. As a result the potential of the floating gate electrode is lowered. Also, the channel width changes partly.

On the other hand, according to the configuration of the memory cell shown in Figure 4, even if the deviation occurs by the similar extent as in the configuration shown in Figure 1, the overlapping area of the source region and the floating gate electrode scarcely increases, the capacity created between the floating gate electrode and the substrate inclusive of the channel scarcely increases and the potential of the floating gate electrode is scarcely lowered. Also no undesirable effect is applied on the channel region. The reason of this that the size of the memory cell of Figure 4 is decreased in the row direction thereof, though size in the column direction is increased.

When compared the memory cells shown in Figures 1, 3 and 4, the size of the memory cells in the row direction can be made small as described in the following order,

Figure 1>Figure 3>Figure 4

in case the capacity between the floating gate electrode and the control gate electrode in each of the memory cells in Figures 1, 3 and 4 is the same. Accordingly, the allowance for the possible deviation from the proper mask alignment during the PEP of the memory cell of Figure 4 is larger than those shown in Figures 1 and 3, and that shown in Figure 3 is larger than that shown in Figure 1.

In the above-mentioned embodiment, only the facing area between the floating gate electrode and control gate electrode is taken into account for the increase of the capacity between these gate electrodes. It is to be understood, however, that the capacity can generally be changed according to the distance between two facing electrodes and the dielectric constant of a dielectric interposed between the electrodes, besides the facing area therebetween, and that such changing methods may additionally be applied to the above embodiment.

### Claims

1. A nonvolatile semiconductor memory device comprising:

a semiconductor substrate (30) of one conductivity type,

a drain region (32b) which has two end portions and is formed on a major surface of said semiconductor substrate (30);

a contact hole (33b) formed substantially in the middle of the drain region (32b) between said two end portions,

first and second source regions (31a, 31b) formed on both sides of the drain region (32b), respectively, in such a way as to be spaced apart from the two end portions of the drain region (32b) by a predetermined distance,

first and second channel regions respectively formed between one end of the drain region (32b) and the first source region (31a), and between the other end of the drain region (32b) and the second source region (31b),

first and second floating gate electrodes (34b, 34d) formed on gate insulation films (43) overlying both said first and second channel regions respectively, and

first and second control gate electrodes (35a, 35b) formed on another gate insulation film (45) overlapping said floating gate electrodes (34b, 34d) and extending along the longitudinal direction of the channels, between the source regions and the corresponding drain regions,

the width of each of said floating gate electrodes (34b, 34d) and control gate electrodes (35a, 35b) being narrower at those portions which are located over said channel than at portions which are not located over said channel,

those side edges of the first and second floating and control gate electrodes (34b, 34d; 35a, 35b) which face to first and second source regions (31a, 31b) being substantially parallel with each other and extending in a substantial straight direction along the side edges of the source regions (31a, 31b),

those portions of said floating and control gate electrodes (34b, 34d; 35a, 35b) which are not located over said channel protruding towards a direction parallel to the source-drain-direction at a given distance from said drain contact hole (33b), characterized in that those side edges of the first and second floating and control gate electrodes (34b, 34d; 35a, 35b) which face to first and second source regions (31a, 31b) and those said side edges of the source regions (31a, 31b) are substantially in line with each other, and

that all those said portions of said floating and control gate electrodes (34b, 34d; 35a, 35b) which are not located over said channel, protrude towards said drain region (32b) at a given distance from said drain contact hole (33b).

2. The nonvolatile semiconductor memory device according to Claim 1, characterized in that those side edges of the protruding portions of the first and second floating and control gate electrodes (34b, 34d; 35a, 35b) which face to said drain contact hole (33b) are so inclined that a predetermined distance is maintained between said side edges and said drain contact hole (33b).

**Patenansprüche**

1. Nicht-flüchtige Halbleiterspeichervorrichtung mit:

einem Halbleitersubstrat (30) eines Leitungstyps,

einem Drainbereich (32b), der Endteile aufweist und auf einer Hauptoberfläche des Halbleitersubstrates (30) ausgebildet ist,

einem im wesentlichen in der Mitte des Drainbereiches (32b) zwischen den beiden Endteilen ausgebildeten Kontaktloch (33b),

einem ersten und einem zweiten Sourcebereich (31a, 31b), die jeweils auf beiden Seiten des Drainbereiches (32b) so ausgebildet sind, daß sie von den beiden Endteilen des Drainbereiches (32b) um einen vorbestimmten Abstand entfernt sind,

einem ersten und einem zweiten Kanalbereich, die jeweils zwischen einem Ende des Drainbereiches (32b) und dem ersten Sourcebereich (31a) und zwischen dem anderen Ende des Drainbereiches (32b) und dem zweiten Sourcebereich (31b) ausgeführt sind,

einer ersten und einer zweiten freischwebenden Gateelektrode (34b, 34d), die auf den bzw. zweiten Kanalbereich überlagernden Gate-Isolations-filmen (43) ausgeführt sind, und

einer ersten und einer zweiten Steuergateelektrode (35a, 35b) die auf einem anderen Gateisolationsfilm (45), die freischwebenden Gateelektroden (34b, 34d) überlappende und sich in der Längsrichtung der Kanäle erstrekend zwischen den Sourcebereichen und den entsprechenden Drainbereichen ausgeführt sind,

wobei die Breite jeder der freischwebenden Gateelektroden (34b, 34d) und Steuergateelektroden (35a, 35b) an denjenigen Teilen, die über dem Kanal liegen, schmaler ist als an Teilen, die nicht über dem Kanal liegen,

wobei Seitenkanten der ersten und zweiten freischwebenden Gateelektroden und der Steuergateelektroden (34b, 34d; 35a, 35b) die dem ersten und zweiten Sourcebereich (31a, 31b) gegenüber liegen, im wesentlichen parallel zueinander verlaufen und sich in einer im wesentlichen geraden Richtung längs der Seitenkanten der Sourcebereiche (31a, 31b) erstrecken,

wobei diejenigen Teile der freischwenden Gateelektroden und der Steuergateelektroden (34b, 34d; 35a, 35b), die nicht über dem Kanal liegen, sich in einer Richtung parallel zu der Source-Drain-Richtung in einem gegebenen Abstand vom Drainkontaktloch (33b) erstreken, dadurch gekennzeichnet,

daß diejenigen Seitenkanten der ersten und zweiten freischwebenden Gateelektroden und der Steuergateelektroden (34b, 34d; 35a, 35b), die dem ersten und zweiten Sourcebereich (31a, 31b) gegenüber liegen, und diese Seitenkanten der Sourcebereiche (31a, 31b) im wesentlichen in einer Linie miteinander sind, und

daß alle diejenigen Teile der freischwebenden Gateelektroden und der Steuergateelektroden (34b, 34d; 35a, 35b), die nicht über dem Kanal liegen, sich zum Drainbereich (32b) in einem gegebenen Abstand vom Drainkontaktloch (33b) erstreken.

2. Nicht-flüchtige Halbleitervorrichtung nach Anspruch 1, dadurch gekennzeichnet, daß die diejenigen Seitenkanten der vorspringenden Teile der ersten und zweiten freischwebenden Gateelektroden und der Steuergateelektroden (34b, 34d; 35a, 35b), die dem Drainkontaktloch (33b) gegenüber liegen, so geneigt sind, daß ein vorbestimmter Abstand zwischen diesen Seitenkanten und dem Drainkontaktloch (33b) aufrecht erhalten wird.

**Revendications**

1. Dispositif de mémore semiconducteur permanent comprenant:

un substrat semiconducteur (30) d'un premier type de conductivité,

une région de drain (32b) qui possède deux parties terminales et est formée sur une surface principale dudit substrat semiconducteur (30),

un trou de contact (33b) formé sensiblement au milieu de la région de drain (32b) entre lesdites deux parties terminales,

une première et une deuxième région de source (31a, 31b) formées sur les deux côté respectifs de la région de drain (32b) de manière à être séparées des deux parties terminales de la région de drain (32b) d'une distance prédéterminée,

une première et une deuxième région de canal respectivement formées entre une extrémité de la région de drain (32b) et la première région de source (31a) et entre l'autre extrémité de la région de drain (32b) et la deuxième région de source (31b),

une première et une deuxième électrode de grille flottante (34b, 34d) formées sur des pellicules (43) d'isolation de grille recouvrant respectivement lesdites première et deuxième régions de canal, et

une première et une deuxième électrode de grille de commande (35a, 35b) formées sur une autre pellicule (45) d'isolation de grille, chevauchant lesdites électrodes de grille flottante (34b, 34d) et s'étendant le long de la direction longitudinale des canaux, entre les régions de source et les régions de drain correspondantes,

la largeur de chacune desdites électrodes de grille flottante (34b, 34d) et des électrodes de grille de commande (35a, 35b) étant plus étroite au niveau des parties qui sont situées au-dessus dudit canal qu'au niveau des parties qui ne sont pas situées au-dessus dudit canal,

les bords latéraux des premièrs et deuxièmes électrodes de grille flottante et de grille de commande (34b, 34d; 35a, 35b) qui sont en regard des première et deuxième régions de source (31a, 31b) étant sensiblement parallèles entre eux et s'étendant suivant une direction sensiblement rectiligne le long des bords latéraux des régions de source (31a, 31b),

les parties desdites électrodes de grille flottante et de grille de commande (34b, 34d; 35a, 35b) qui ne sont pas situées au-dessus dudit canal faisant saillie vers une direction parallèle à la direction source-drain à une distance donnée dudit trou de contact de drain (33b), caractérisé en ce que:

les bords latéraux des premières et deuxièmes électrodes de grille flottante et de grille de commande (34b, 34d; 35a, 35b) qui sont en regard des première et deuxième régions de source (31a, 31b) et lesdits bords latéraux des régions de source (31a, 31b) sont sensiblement alignés entre eux, et

toutes lesdites parties desdites électrodes de grille flottante et de grille de command (34b, 34d; 35a, 35b) qui ne sont pas situés au-dessus dudit canal font saillie en direction de ladite région de drain (32b) à une distance donnée dudit trou de contact de drain (33b).

2. Dispositif de mémoire semiconducteur permanent selon la revendication 1, caractérisé en ce que les bords latéraux des parties saillantes des premières et deuxièmes électrodes de grille flottante et de grille de commande (34b, 34d; 35a, 35b) qui sont en regard dudit trou de contact de drain (33b) sont inclinés de façon qu'une distance prédéterminée soit maintenue entre lesdits bords latéraux et ledit trou de contact de drain (33b).

# F I G. 1

# F I G. 2

# F I G. 3

# F I G. 4

# F I G. 5